# EUROPEAN PATENT APPLICATION

(11) **EP 0 717 286 A2**
(43) Date of publication of application: **19.06.1996**
(21) Application number: 95309022.2
(22) Date of filing: 12.12.1995
(51) Int. Cl.: G01R 21/133

(54) **Commodity consumption meters**

(30) Priority: 16.12.1994 GB 9425411; 03.07.1995 GB 9513458
(71) Applicant: THE GENERAL ELECTRIC COMPANY, p.l.c., London W1A 1EH (GB)
(72) Inventor: Jones, Alan John, Staffordshire, ST5 3BA (GB); Clowes, Darren James, Stoke on Trent, Staffordshire, ST4 8QX (GB)
(74) Representative: Hoste, Colin Francis

(57) **Abstract**

Apparatus is provided for use with a commodity consumption meter (2), of a type having a sealed housing (3, 4, 6) and including a rotating component (14) whose rate of rotation depends upon the rate of consumption of the commodity, the rotating component being visible through a wall of the sealed housing. The apparatus comprises: a casing (38) which substantially completely covers the wall of the meter (2) and includes a transparent region (62) through which the rotating component (14) can be viewed and an optical assembly (64) for monitoring rotation of the rotating component. Preferably the optical assembly (64) comprises a light source (66) which is amplitude modulated at a selected frequency and is arranged to direct light (70) through the housing onto the rotating component (14) and a light detector (68) to detect reflected light (74) from the rotating component (14), the apparatus further including a synchronous detector circuit (82) connected to the detector (68) and operated at the selected frequency and processing means (96) arranged to count the number of revolutions of the component (14) using the output signal from the synchronous detector circuit (82).

## Description

This invention relates to commodity consumption meters, for example electricity, gas or water consumption meters and in particular to apparatus for use with such meters.

With the privatisation of the United Kingdom's (UK's) Electricity Companies, new market opportunities have arisen for the supply of electricity to both industrial and domestic consumers alike. The Regional Electricity Companies (RECs) who currently supply electricity within the UK purchase electricity from a pool. The various electricity generating companies, e.g. Nuclear Electric, Powergen, etc, place tenders to supply electricity to the pool in which the electricity is traded and priced on a half-hourly basis with settlement of an REC's purchase occurring at the end of a one month period. It is proposed to extend this system so that industrial and domestic consumers will be able to select which REC they purchase electricity from irrespective of their geographic location in relation to their selected REC and irrespective of which REC owns the cabling connecting the customer to the electricity network. To enable the REC to settle payment for supplying energy to a customer situated in the territory of another REC, it will be necessary to log, every half hour, the number of units of electricity supplied for each customer over a one month period.

Electronic electricity consumption meters which are capable of logging electricity consumption in these half-hourly periods, and which then convey this information to the supplier using a radio link, have been developed for industrial customers. However, these meters can be expensive and as a result it is generally only high electricity consumers, or newly built industrial units, that are currently installing these meters.

As regards the domestic market, it has been estimated that there are currently in excess of twenty-three million domestic consumer electricity consumption meters in operation within the UK. Of these the majority, in excess of twenty million, are Ferraris-type mechanical meters which have an operating life expectancy of up to twenty-five years, a million or so are electronic meters with mechanical cyclometer or dial registers and the remainder are pre-paid electronic meters which incorporate liquid crystal displays. Nearly all of these meters are capable only of recording the total number of units of electricity consumed and would therefore need either to be replaced or modified. Replacing these meters is unlikely to be cost effective, even when the cost of the replacement unit is low, due to the high installation costs. Modifying existing meters is also likely to be prohibitively expensive since it will almost certainly involve gaining access to the interior of the sealed meter housing, which would then need to be re-sealed by an appropriate authority to guarantee the accuracy of the meter, further adding to the cost.

It is also proposed to sell gas on a similar basis, compounding the problem further. Current trends indicate that other parts of the world may shortly adopt similar systems following the UK's lead. A need exists therefore for an apparatus which enables electronic reading of commodity consumption meters without damage to their sealed housings.

According to the present invention there is provided apparatus for use with a commodity consumption meter, of a type having a sealed housing and including a rotating component whose rate of rotation depends upon the rate of consumption of the commodity, the rotating component being visible through a wall of the sealed housing, the apparatus comprising: a casing which substantially completely covers the wall of the meter and includes a transparent region through which the rotating component can be viewed, and an optical assembly for monitoring rotation of the rotating component.

Preferably the optical assembly comprises a light source which is amplitude modulated at a selected frequency and is arranged to direct light through the housing onto the rotating component and a light detector to detect reflected light from the rotating component, the apparatus further including a synchronous detector circuit connected to the detector and operated at the selected frequency and processing means arranged to count the number of revolutions of the component using the output signal from the synchronous detector circuit.

One embodiment of the present invention will now be described, by way of example, with reference to the accompanying drawings, in which:-
Figure 1 is an exploded perspective view of an arrangement comprising an electricity consumption meter and an apparatus in accordance with the invention;
Figure 2 illustrates a fixing arrangement of Figure 1;
Figure 3 illustrates an optical arrangement of the arrangement of Figure 1;
Figure 4 is a block diagram of circuitry of the arrangement of Figure 1;
Figure 5 is a block diagram of further circuitry of the arrangement of Figure 1;
Figure 6 illustrates alternative optical arrangements of the arrangement of Figure 1; and
Figure 7 illustrates a window arrangement of Figure 1.

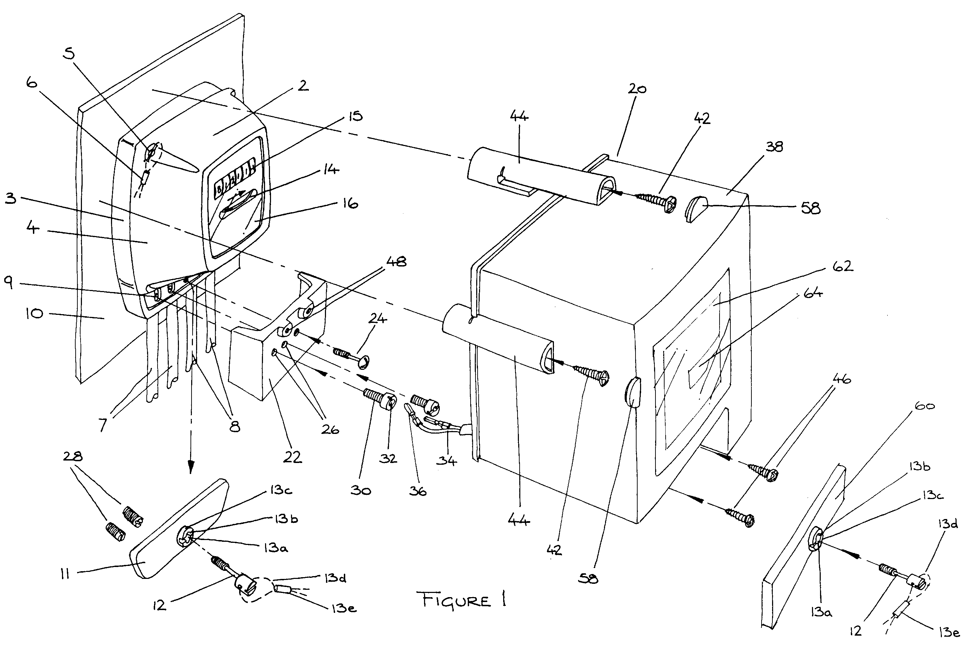

Referring to Figure 1, there is shown an electricity consumption meter 2 of a type known in the art. The meter 2 comprises housing parts 3, 4 which are held together by bolts 5 which are sealed by means of a seal arrangement 6. The seal arrangement 6 is applied by a certifying authority, usually the manufacturer of the meter, to certify the accuracy of the meter whilst the seal remains unbroken.

Electricity is supplied to, and drawn from, the meter 2 using respective pairs of power inlet cables 7 and power outlet cables 8 which are connected to the meter 2 using screw terminals 9.

In installation, the meter 2 is secured to a supporting surface 10 using three screw fixings (not shown). Once the cabling 7, 8 has been connected to the meter 2, a screw terminal cover plate 11 is fitted over the screw terminals 9 and held in place with a retaining screw 12. To prevent an unauthorised person tampering with the operation of the meter 2, for example by removing the cover plate 11 and reconnecting cables 7, 8 so as to bypass the meter 2, the retaining screw 12 is prevented from being extracted by sealing means 13a-e. The sealing means 13a-e can be applied by (i) tightening the retaining screw 12 to align a hole 13a in the screw 12 with a slot 13b in a moulded section 13c which surrounds the screw 12, (ii) passing a piece of wire 13d through the slot 13b and hole 13a and (iii) securing ends of the wire 13d together by crimping them in a seal 13e made of lead. Any attempt to remove the screw 12 will result in the wire 13d being severed, indicating that the meter 2 has been tampered with.

The meter illustrated in Figure 1 is a Ferraris-type induction meter which includes a Ferraris disc 14 whose rate of rotation is proportional to the rate of consumption of electricity. The total number of units of electricity consumed is indicated by means of a plurality of cyclometer registers 15 which are visible through a window 16 in the front face of the housing 4.

To fit the apparatus 20 of the present invention the cover plate retaining screw 12 and terminal cover plate 11 are removed and a plate 22 secured over the screw terminals 9 using a screw 24 which engages in the retaining screw hole. The plate 22 has two holes 26 which align with, and allow access to, grub screws 28 of the screw terminals 9 for the inlet cables 7. The grub screws 28 are replaced with bolts 30 which have a hole 32 running along their axis. Electrical power is provided to the apparatus 20 by means of wires 34 which have plugs 36 which push into the holes 32 in the bolts 30.

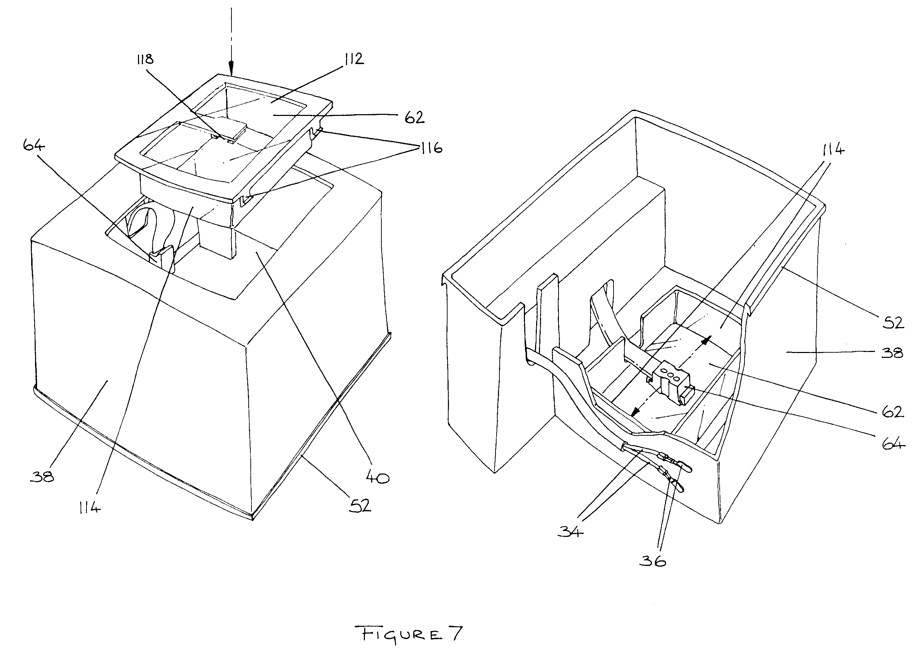

A casing 38, which is open at the rear, is positioned over the sealed meter 2 to substantially enclose the meter 2. A cut out portion 40 (see Figure 7) is provided in the casing 38 to allow it to fit over the cabling 7, 8. The casing 38 is held in place by means of screws 42 which pass through fixtures 44 into the supporting surface 10 and by screws 46 which pass through the casing 38 and engage in holes 48 in the plate 22. As well as securing the casing 38 the fixtures 44 also ensure that the rear edge of the casing 38 is spaced away from the supporting surface 10 to ensure that the casing 38 does not foul any cabling, or other obstructions, that may be present.

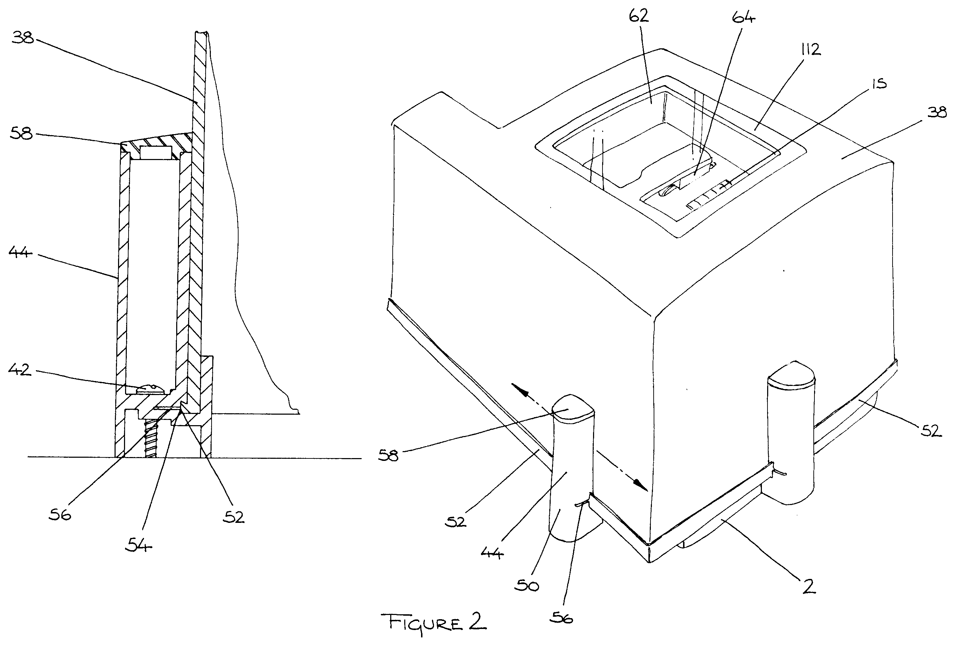

Referring to Figure 2 the fixtures 44 are shown in more detail and comprise a generally hollow cylindrical shaped body 50. Running around a lip of the casing 38 is a chamfered rim 52. A corresponding slot 54 in the body 50 of the fixture 44 engages with the rim 52. A slit 56 which starts within the slot 54 and extends part the way through the body 50 in a plane perpendicular to the axis of the body 50 is provided to enable the fixture 44 to be snapped into place on the rim 52. The fixture can then be slid along the rim 52 to the desired position and finally clamped in place by means of the screw 42. Finally a cap 58 is pushed into the open end of the fixture 44 to cover the screw 42.

Referring back to Figure 1, to complete the installation of the apparatus 20 a cover plate 60 is fixed to the plate 22 to prevent unauthorised tampering with the apparatus by means of the retaining screw 12 and sealed using the wire 13d and seal 13e arrangement described.

A transparent window 62 is provided in the front face of the casing 38 to allow the cyclometer registers 15 to be read when the casing 38 is fitted to the meter 2. An optical assembly 64 mounted on the inner surface of the window 62 is provided for detecting rotation of the disc 14. The casing 38 also contains electrical circuitry, which is described later, for operating the optical assembly 64 and counting the number of revolutions of the disc 14. As described above electrical power for the circuitry is provided by the wires 34 which plug into the bolts 30 on the inlet power side.

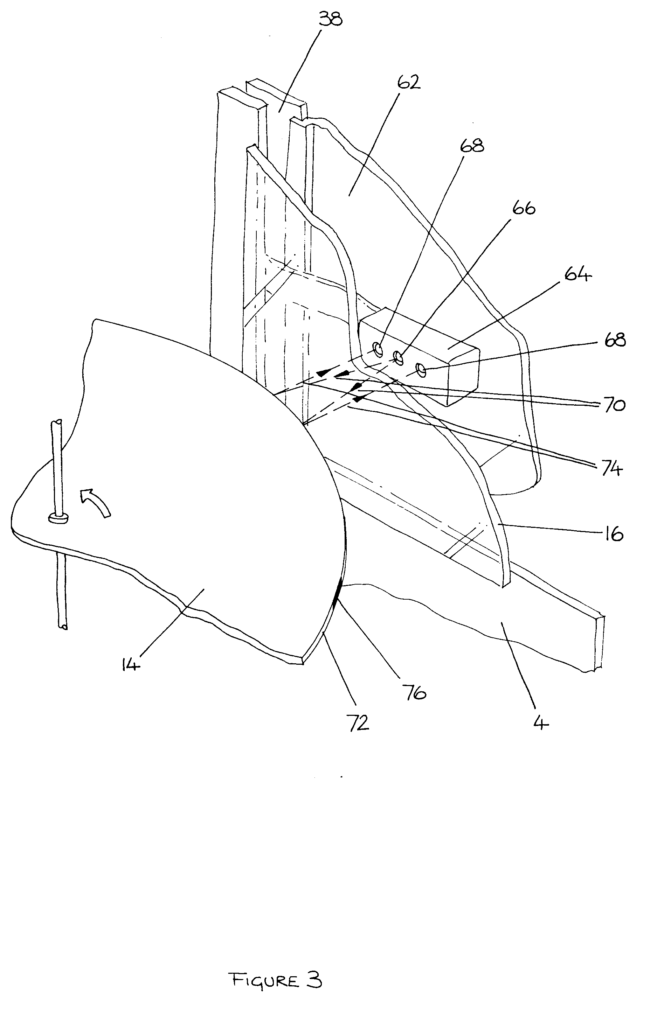

Referring to Figure 3, the optical assembly 64 comprises a light source 66 in the form of an infra red light emitting diode (LED) - and a light detector 68. The LED 66 is arranged to direct light 70 through the window 16 in the meter housing 4 onto an edge 72 of the disc 14. Light 74 reflected from the edge 72 of the disc 14 back through window 16 is sensed by the light detector 68. The disc 14 includes a mark 76 on its edge 72 and rotation of the disc 14 causes this mark 76 to modulate the light 74 reflected back to the light detector 68. The modulation in the detector output is used to calculate the number of revolutions of the disc 14. Adjusting means (not shown) can be provided to enable the optical assembly 64 to be aligned with the disc 14 prior to fitting the apparatus.

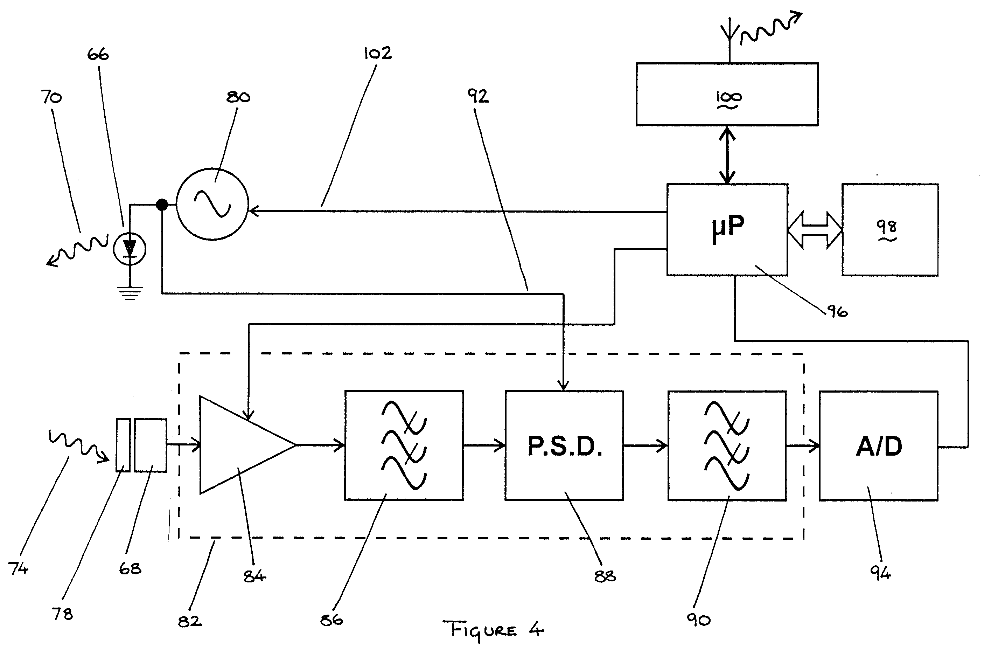

A daylight filter 78 (see Figure 4) is provided in front of the detector 68 to reduce the effects of stray light, for example sunlight, which originates from sources other than from the LED 66 though in alternative embodiments it can be omitted. The filter 78 is selected such that it substantially attenuates light of wavelengths other than those produced by the LED 6 to reduce strong sources of stray light saturating the detector or masking the modulation resulting from the rotation of the disc. Preferably, the detector 68 also has a restricted field of view to further reduce the level of stray light reaching the detector 68.

Referring to Figure 4 the driving and processing circuitry are shown. The light source 66 is amplitude modulated at a selected frequency using an oscillator 80 and the detector's output synchronously demodulated at the selected frequency using a synchronous detector circuit 82, sometimes referred to as a lock-in-amplifier circuit. Operating the LED 66 and synchronous detector circuit 82 at a selected frequency prevents fluorescent lights and other modulated light sources affecting the detector's output. The synchronous detector circuit 82 comprises a variable gain amplifier 84, a band pass filter 86, a phase sensitive demodulator (PSD) 88 and a low pass filter 90 connected in series. The oscillator 80, in addition to driving LED 66, generates a reference signal 92 for the PSD 88 such that in operation the PSD 88 only allows signals of the same frequency and phase as those of the reference signal 92 to pass. The analogue output from the synchronous detector circuit 82 is converted to a digital signal using an 8 bit analogue to digital (A/D) converter 94. A microprocessor 96 processes this data to determine the number of revolutions of the disc 14. The number of revolutions in a selected period are stored in a memory 98.

A transceiver circuit 100, or other suitable communication means, is connected to the microprocessor 96 which, in response to an interrogation signal from a remote base station, communicates to the base station the number of units consumed in each of the selected periods.

The microprocessor 96 determines the number of revolutions of the disc 14 by logging each time the output from the A/D converter 94 crosses a selected threshold value as the mark 76 passes the optical assembly 64. The threshold value is selected by the microprocessor 96 to be approximately midway between the digital values corresponding to the maximum detector output and the average detector output. The gain of the variable gain amplifier 84 is adjusted by the microprocessor 96 to maximise the dynamic range between the minimum and maximum detector output levels. It is found that, by using this method, reliable operation is obtained for a disc whose edge is clean and in which the mark is clearly defined. However, in some meters the edge 72 of the disc 14 may be corroded or buckled and the mark may be worn. Such faults can cause the detector's output to cross the threshold value on more than one occasion for a single revolution of the disc, which could result in the microprocessor 96 over-reading the number of revolutions. In any event, though, one revolution of the disc 14 will produce a particular sequence, or signature, unique to that disc, which will repeat on subsequent revolutions. In an alternative embodiment the microprocessor is programmed to analyse the A/D converter's output to establish this signature and subsequently logs a revolution each time the signature repeats.

Such apparatus has been found to operate reliably even when the meter is subjected to extremely high levels of external radiation such as incandescent or fluorescent light. This type of apparatus will doubtless attract the interest of deliberate tamper, for example attempting to reproduce the modulation signal by irradiating the detector 68 through the window 62 using a modulated light source at the selected frequency. To overcome this problem the microprocessor 96 periodically changes the selected frequency of the oscillator 80 using a control line 102 to the oscillator 80. The microprocessor 96 can also be arranged to check for the presence of an interfering signal by turning the LED 66 off whilst still maintaining the reference signal 92 to the PSD 88 and checking for the continued presence of a signal. When a fault is detected the base station can be informed using the transceiver circuit 100.

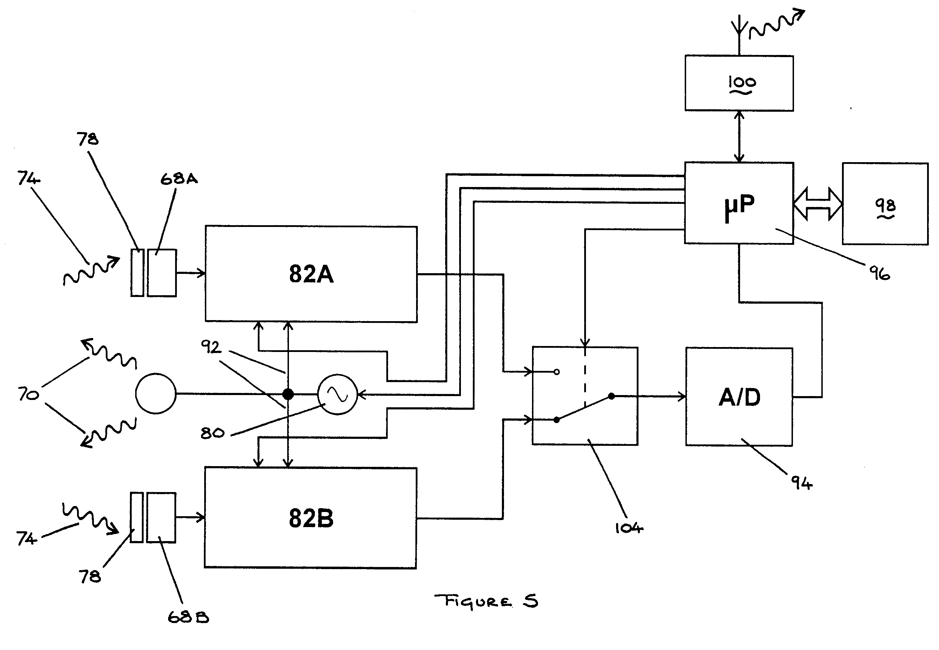

Other forms of deliberate tamper could include arranging the meter to operate in reverse. For example some water consumption meters can be made to operate in reverse by transposing the supply and outlet connections to the meter. In the case of Ferraris type induction meters it has been known to strap an inductive circuit to the meter to inductively impede rotation of the Ferraris disc; during periods of low electricity consumption this can cause the disc to rotate in a reverse direction. To counter such tamper it is therefore preferable to be able not only to log the number of revolutions of the disc 14 but also the direction of rotation of the disc 14. Figure 5 shows an alternative circuit arrangement which enables the direction of rotation of the disc 14 to be determined and which includes two channels, A and B. Each channel has a respective detector 68a, 68b and synchronous detector circuit 82a, 82b and an LED 66 which is common to both the channels and located between the detectors 68a, 68b. The microprocessor 96 processes data from each channel by alternately selecting a channel using a switching means 104. The direction of rotation of the disc 14 can be determined by checking which channel increments first. If the microprocessor 96 detects that the meter is operating in reverse the base station can be alerted using the transceiver circuit 100. It is envisaged that the source and detectors 66, 68a, 68b are integrated into a single package with the daylight filter 78.

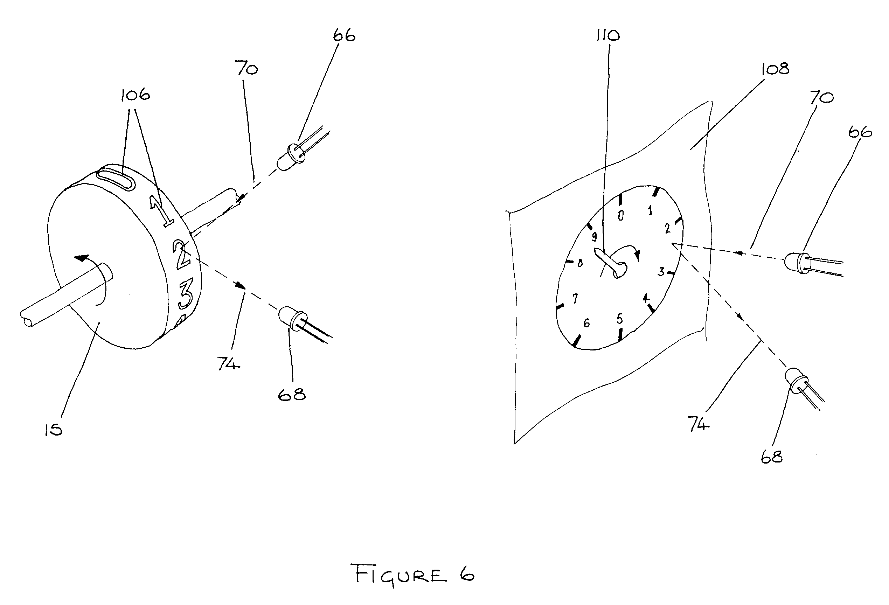

Although the foregoing discussion has been limited to counting the number of revolutions of the Ferraris disc 14 in an electricity consumption meter, the apparatus can be applied to other forms of consumption meters which include cyclometer registers or rotary dial registers as illustrated in Figure 6. In the case of a cyclometer register 15, which are commonly used in electricity, water and gas consumption meters, the light source 66 is arranged to direct light 70 onto the curved surface of the register 15 (Figure 5a). Numerals 106 on the surface of the register 15 will modulate the reflected light 74 with a particular signature. The number of revolutions of the register can be determined by logging each time a repeat of the signature is detected.

In the case of a rotary dial register 108, which are often found in gas consumption meters, a pointer hand 110 cuts the incident light beam 70 as it revolves. The number of revolutions can be determined using the simple threshold value previously described. It will be appreciated therefore that the present invention can be applied to any commodity consumption meter which includes a rotating component whose rate of rotation depends upon the rate of consumption of the commodity.

As described above, the power required to drive the circuitry in Figures 4 or 5 can be provided using wires 34 which are connected to the meter's terminals 9. In an alternative arrangement an insulation displacement connector (IDC) is attached to the power outlet cables 8 of the meter 2 and the wires 34 connected to the IDC. Such an arrangement has the advantage that the terminal cover plate 11 need not be removed to install the apparatus. If the meter 2 is fitted with an isolating switch the wires 34 could alternatively be connected to the isolating switch. In the case of meters which may be solely mechanical, for example water and gas consumption meters, power for the circuitry could be provided from a battery located in the casing 38.

Referring to Figure 7, a preferred casing arrangement is illustrated in which the transparent window 62 is provided as a separate snap-in window module 112. The window module incorporates a bezel 114 which extends towards the front face of the meter 2. The bezel 114 prevents an unauthorised user from tampering with the optical assembly for example by attempting to feed a shim of metal under the casing in front of the optical assembly 64. The window module 112 includes lugs 116 which engage under the inner surface of the casing 38. The lugs 116 are arranged to allow the module to be snapped into place and have weak regions moulded into them such that any attempt to remove the window module 112 will result in the lugs 116 fracturing indicating that the apparatus has been tampered with. The window module 112 also includes a fastening arrangement 118 on the inner surface of the transparent window 62 to receive the optical assembly 64. An advantage of having a separate window module 112 is that a given size casing 38 can be used to fit a number of different sized consumption meters 2 and only the window module 112, which is inexpensive to manufacture, need be of a size appropriate to the particular meter. In particular the size of the bezel 114 is tailored to a given meter to reduce any likelihood of mechanical tamper.

Whilst in the above description the casing 38 has been illustrated as generally enclosing the meter 2 it will be appreciated that other arrangements are envisaged within the scope of the invention. For example in an alternative arrangement the casing 38 covers only the front face of the meter. Such an arrangement is useful when access around the meter is limited due to for example cabling or further meters. In any event the casing should substantially cover the front face to prevent tamper with the optical assembly 64.

## Claims

1. Apparatus for use with a commodity consumption meter (2), of a type having a sealed housing (3, 4, 6) and including a rotating component (14) whose rate of rotation depends upon the rate of consumption of the commodity, the rotating component (14) being visible through a wall of the sealed housing (3, 4, 6), the apparatus characterised by a casing (38) which substantially completely covers the wall of the meter (2) and includes a transparent region (62) through which the rotating component (14) can be viewed and an optical assembly (64) for monitoring rotation of the rotating component (14).

2. Apparatus according to claim 1 in which the optical assembly (64) comprises a light source (66) which is amplitude modulated at a selected frequency and is arranged to direct light (70) through the housing (3, 4) onto the rotating component (14) and a light detector (68) to detect reflected light (74) from the rotating component (14), the apparatus further including a synchronous detector circuit (82) connected to the detector (68) and operated at the selected frequency and processing means (96) arranged to count the number of revolutions of the component (14) using the output signal from the synchronous detector circuit (82).

3. Apparatus according to claim 1 or claim 2 in which the wall is a front wall of the meter.

4. Apparatus according to any one of claims 1 to 3 in which the casing (38) extends partly over sides of the sealed meter housing (3, 4, 6) which are adjacent to the wall.

5. Apparatus according to any one of claims 1 to 3 in which the casing (38) substantially encloses the meter (2).

6. Apparatus according to any preceding claim further comprising sealing means (13) for preventing unauthorised removal of the casing (38).

7. Apparatus according to any preceding claim further comprising fixtures (44) for securing the casing (38) to a supporting surface (10) to which the meter (2) is mounted in which the fixtures (44) are attached to the casing (38) by means of a groove (54) in the fixture (44) which engages with a rim (52) on an edge of the casing (38).

8. Apparatus according to any preceding claim in which the transparent region (62) of the casing (38) is attached to the casing (38) by means of a clip fastening (116) and includes a bezel (114) which extends toward the wall of the meter.

9. Apparatus according to any preceding claim including adjusting means for aligning the source (66) and detector (68) with the rotating component (14).

10. Apparatus according to any preceding claim including a further detector (68B) to enable the direction of rotation of the component (14) to be determined.

11. Apparatus according to any preceding claim in which the processing means (96) calculates the rate of rotation by measuring the time taken for a particular pattern in the output signal of the synchronous detector circuit (82) to repeat.

12. Apparatus according to any preceding claim in which each detector (68) has a filter (78) in front of it to substantially attenuate light of wavelengths other than that produced by the light source (66).

13. Apparatus according to any preceding claim in which the selected frequency for modulating the light source (66) and operating the synchronous detector circuit (82) are periodically changed.

14. Apparatus according to any preceding claim in which the light source (66) is periodically switched off and the detector (68) and synchronous detector circuit (82) operated to detect for the presence of interference.

15. Apparatus according to any preceding claim in which the rotating component (14) is a Ferraris disc and the light source (66) directs light onto the edge (72) of the disc.

16. Apparatus according to any of claims 1 to 14 in which the rotating component (14) is a cyclometer register (15).

17. Apparatus according to any one of claims 1 to 14 in which the rotating component (14) is a pointer hand (110) of a dial register (108).
